# EUROPEAN PATENT APPLICATION

(11) **EP 1 973 272 A1**
(43) Date of publication of application: **24.09.2008**
(21) Application number: 07447023.8
(22) Date of filing: 20.03.2007
(51) Int. Cl.: H04L 12/28

(54) **Combiner with active balun for providing broadband internet access on catv networks**

(71) Applicant: Dinh-Debouny, Huu-Tung, 4430 Ans (BE)
(72) Inventor: Dinh-Debouny, Huu-Tung, 4430 Ans (BE); Labro, Marc, 4130 Tilf (BE)
(74) Representative: pronovem

(57) **Abstract**

The present invention is related to a conversion circuit (1) for connecting bi-directionally a balanced line to an unbalanced line, called active balun, characterised in that it comprises a first transmit line and a second receive line both linked via an input connector (2) to the balanced line, each line being provided with an impedance adapter (4,4'), linked to a corresponding amplifier (5,5') respectively, the output of the transmit line amplifier (5) and the input of the receive line amplifier (5') being connected to a splitter/combiner (6), said splitter/combiner (6) being linked via an output connector (3) to the unbalanced line.

## Description

### Field of the invention

The present invention is related to combiners or splitters including baluns and diplex filters suitable to be used in technologies related to high frequency broadband signal transportation on a common line.

In particular, the invention finds an advantageous application in combining data such as bidirectional Ethernet information with CATV on coax cables and networks.

### Prior art

Recently, broadband internet access for subscribers in residential buildings has become very widespread by utilising classical twisted-pairs phone lines (DSL, ADSL, VDSL, etc.) or CATV coaxial networks.

In the latter case, this was rendered possible by the fact that data signals and TV signals use different parts of the frequency spectrum. Typically data are transmitted from DC to lower frequencies, for example the base band signal of 10 Mb/s according to the Ethernet protocol (10 Base-T) is approximately in the range 0-25 MHz, while TV signal is typically comprised between 47 and 860 MHz.

This kind of technologies has provided numerous advantages such as delivering TV signal through existing phones lines, delivering broadband internet access to individual subscribers, economising on costly and less reliable data network cables (UTP), etc.

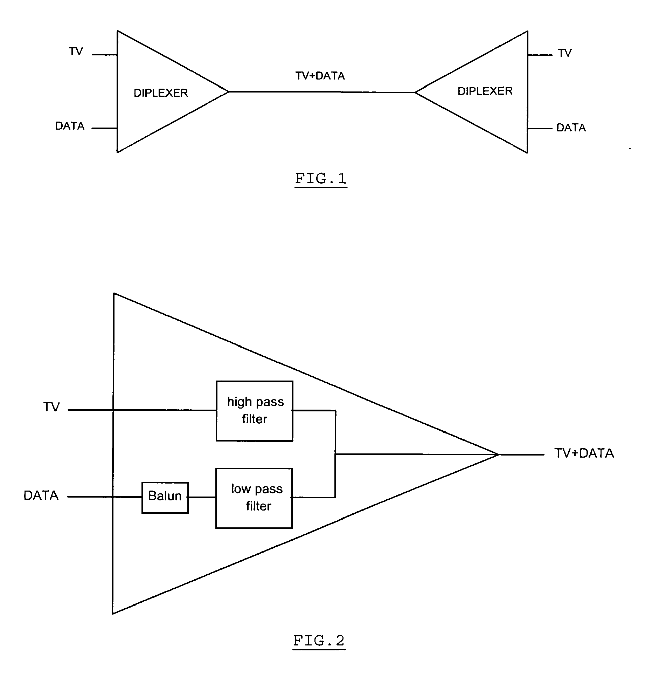

TV and data signals can be mixed on a common line, for example a 75 Ω coaxial cable, by using a combiner made of a diplex filter (or diplexer), which is a low-pass and a high-pass filter combination. Inversely, separation of the combined signal can be obtained by using a similar splitter made of an inverse diplex filter. The basic principle for transportation of TV and data signals on a common line is illustrated on FIG.1. Hereinafter the combining device will be practically referred to as the "local" device, whilst the separation device will be referred to as the "remote" device.

Prior art diplex filters, as shown schematically on FIG.2 (see also patent application EP 1 383 329), typically comprises a first input port for TV signal (F-connector for coax line), a second input port for data (RJ45 for twisted-pairs line) and an output port for the combined signal (F-connector for coax line). Before combination, the TV signal undergoes high-pass filtering, while the data signal undergoes low-pass filtering. Moreover a passive balun is interposed between the second input port and the low-pass filter. A balun (for *balanced-unbalanced*) is a device that joins a balanced line having two conductors with equal currents in opposite directions, such as a twisted-pairs cable (e.g. UTP), to an unbalanced line, such as a coaxial cable having only one conductor and a ground. In the present application the balun has a function of impedance adaptor between the Ethernet line (twisted pairs, UTP, STP ; 100 Ω) and the coaxial cable (75 Ω). Usual voltage transformers are known to be simple baluns.

Prior art diplex filters are equipped with very rudimentary baluns which render them poorly reliable, especially when connected to 100 Base-T equipments and when used in full duplex mode, whatever the speed 10 Base-T or 100 Base-T.

### Aims of the invention

The present invention aims to provide a solution which is free from well-known drawbacks of prior art.

In particular the invention is intended to provide diplex filters adapted for cable-saving technologies and equipped with reliable baluns or impedance adapters.

### Summary of the invention

A first object of the present invention relates to a conversion circuit for connecting bidirectionally a balanced line to an unbalanced line, called active balun, characterised in that it comprises a first transmit line and a second receive line both linked via an input connector to the balanced line, each line being provided with an impedance adapter, linked to a corresponding amplifier, the output of the transmit-line amplifier and the input of the receive-line amplifier being connected to a splitter/combiner, said splitter/combiner being linked via an output connector to the unbalanced line.

According to one preferred mode of the invention, the balanced line is a twisted-pair data line and the input connector is a 4-pins/2-pairs Ethernet connector such as a RJ45 connector, the twisted-pair data line being a 100 Ω nominal line suitable for use according to the Ethernet protocol with a base band signal rate of 10 Mb/s or 100 Mb/s, the Transmit Data pins (TX+, TX-) being connected to the first line and the Receive Data pins (R+, R-) being connected to the second line.

Preferably, the unbalanced line is a 75 Ω coaxial line and the output connector is a RF connector.

Advantageously, the impedance adapters (4,4') are transformers having the same turn ratio equal to Nbal:Nunbal, which is preferably equal to 2/sqrt(3).

According to more preferred modes of the invention, the balun can be configured for connecting remote power over the coaxial line with current limitation. It can also be adapted for Ethernet Auto-Negotiation and 10 Base-T/100 Base-T half and full duplex mode.

According to other preferred modes, the balun can be configured to:
- compensate for cable attenuation or to
- simulate the desired cable characteristics or to
- provide amplifier gains so that to tune overall loss.

According to still another preferred mode, said first and second amplifiers are active low-pass filters, i.e. operational amplifiers turned into low-pass filters.

According to still another preferred mode, a group delay equalizer to compensate for the group delay of the low pass filter, preferably up to 100 MHz, is inserted between each impedance adapter and its corresponding amplifier. So the return loss can be improved.

According to other preferred modes, the amplifiers have dual supply, i.e. positive and negative voltage supply and the splitter/combiner is a high isolation splitter.

A second object of the invention is a network interface unit, preferably for 10/100 Base-T Ethernet and analogue TV applications, comprising at least one input, one output respectively, for an unbalanced analogue TV signal and one input, one output respectively, for a balanced data signal, at least one signal combiner, splitter respectively, for said unbalanced and said balanced signals and one output, one input respectively, for a combined unbalanced signal, characterised in that it further comprises an active balun as described above, located between said balanced data signal input and an input of said combiner, between an output of said splitter and said balanced data signal output respectively.

In a preferred embodiment of the network interface unit, the input, output respectively, for unbalanced analogue TV signal and the output, input respectively, for said combined unbalanced signal are coax RF connectors while the input, output respectively, for balanced data signal is a twisted-pair, preferably RJ45, connector.

In another preferred embodiment, the network interface unit comprises a low-pass filter, preferably in the band 0-100 MHz, for filtering the data signal and a high-pass filter, preferably in the band 132-860 MHz, for filtering the analogue TV signal, before recombination, after splitting respectively, of the two signals.

Another preferred network interface unit, preferably for IP TV applications, comprising at least one input, one output respectively, for a balanced data signal and one output, one input respectively, for the corresponding unbalanced signal, is characterised in that it further comprises an active balun as detailed above, located between said balanced data signal input, output respectively, and said unbalanced data signal output, input respectively.

In a preferred embodiment, the network interface unit comprises a power inserter acting as a remote power supply through the unbalanced line, preferably provided with a current limit element configured so that to switch off the remote power supply in case of short-circuit on the unbalanced line.

### Short description of the drawings

FIG.1 schematically represents the principle for transportation of TV and data signals on a common line.

FIG.2 schematically represents a prior art passive combiner with impedance adapter or balun.

FIG.3 schematically represents the block diagram of an active balun compatible with 10/100 Base-T Ethernet standard, according to a preferred embodiment of the present invention.

### Description of a preferred embodiment of the invention

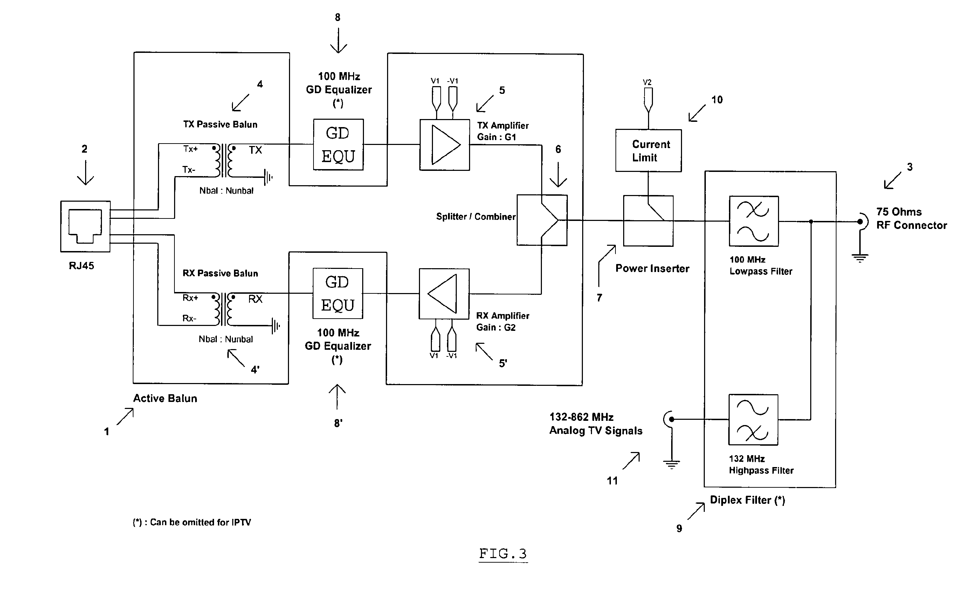

According to the preferred embodiment of the invention shown on FIG.3, the active balun 1 comprises a terminal for a RJ45 connector 2, which is usually used for interfacing twisted-pairs cables, for example LAN cables (Ethernet). Balun 1 also comprises a terminal for a coax connector 3, such as an F-connector, for interfacing coax cables. Note that the device of FIG.3 is more precisely a combiner or "local" device, comprising a diplex filter 9 for combining Ethernet (data) provided through the balun 1 and TV signals entering at coax connector 11. However, a "remote" device can basically correspond to the inverse block diagram of FIG.3 and is also under the scope of the present invention.

Transmit data pins Tx+ and Tx-, receive data pins Rx+ and Rx- respectively, of the RJ45 connector are linked to the input terminals, i.e. the terminals of the primary coil, of a first transformer 4, a second transformer 4' respectively. Both transformers, which are designed for impedance matching, have the same turn ratio Nbal:Nunbal.

The output terminals, i.e. the terminals of the secondary coil, of the respective transformers 4,4' are linked to respective amplifiers 5,5' having respective gains G1 and G2. The output of amplifier 5 and the input of amplifier 5' are connected to a common line via a splitter/combiner 6, whose output is further connected to the coax connector 3. Furthermore a power inserter acting as a remote power supply 7 is provided to the coax line, in order to provide current to the remote device. Advantageously, an intelligent current limit 10 is provided, which allows to switch off the remote power supply in case of short-circuit on the coax line.

Amplification at the signal receiving end advantageously resolves filtering and isolation issues by enabling attenuation of the departing signals. Amplification provides a versatile solution since required minimum voltages are very different for Ethernet (e.g. 4.8 V peak-to-peak in 10 Base-T) and for TV applications (e.g. 1 mV).

In a still preferred embodiment, also shown on FIG.3, on each split line, for improving return loss, a group delay equalizer to compensate for the group delay of the low pass filter 8,8', preferably up to 100 MHz, is inserted between each impedance adapter 4,4' and their corresponding amplifiers 5,5'. It is known that, in digital transmission systems, some distortion of the signal can occur owing to the emission/reception filter cascade, especially when the bandwidth is limited. In particular, a train of pulses can be subjected to intersymbol interference (ISI), which is a distortion causing overlap of individual pulse, which means that previously transmitted symbols have an effect on the currently received symbol. It is also known to suppress ISI by choosing a filter cascade as near as possible of a so-called root raised cosine filter (or a Nyquist filter). With this kind of filter the group delay is constant over the digital signal bandwidth. Usually such a filter is implemented by a signal processing method.

Owing to cost and compact design requirements, diplex filters permitting to combine digital and TV signals are usually made of discrete components. These kind of filters essentially has a group delay variation in the bandwidth of the binary signal all the more great since the filter is selective, which is the case in the present application. Without treatment, these variations would cause, at the receptor level, a great amount of interferences between symbols and further a great error rate and would compromise the integrity of the received data.

According to the preferred embodiment illustrated on FIG.3, a particular filter called "group delay equalizer" is introduced in the circuit to maintain pulse delay variations within tolerable limits.

Moreover, in embodiments designed for accommodating IPTV, there is no combination of TV signals with Ethernet and therefore no diplexer is needed. Consequently, as no low-pass filter is present, no group delay equalizer is needed anymore.

According to the preferred embodiment illustrated in FIG.3, the group delay equalizer filters of the local equipment are optimized to avoid the use of such equalizer in the remote equipment, owing to lack of space in the latter.

According to further preferred embodiments of the invention:
- a low-pass filter is provided with an attenuation, in the 132-862 MHz stop band, optimized to maintain all spurs and harmonics generated in this frequency range by the Ethernet signals and amplifier power supplies, below 10dBµV, that level being requested by CATV distributors to warrant a good quality of analogue TV reception on a TV/FM outlet ;
- the amplifiers 5,5' of the active balun have dual supply, i.e. positive and negative voltage supply (less disturbances, less transient susceptible, less current, smaller components, better signal treatment) ;
- the splitter/combiner (6) is a high isolation splitter.

Still among the advantages of the present invention, the afore-mentioned active balun is fully compatible with Ethernet Auto-Negotiation 10 Base-T/100 Base-T FDx/HDx and DC remote power supply (which has not to be specific).

## Claims

1. Conversion circuit (1) for connecting bidirectionally a balanced line to an unbalanced line, called active balun, **characterised in that** it comprises a first transmit line and a second receive line both linked via an input connector (2) to the balanced line, each line being provided with an impedance adapter (4,4'), linked to a corresponding amplifier (5,5'), the output of the transmit-line amplifier (5) and the input of the receive-line amplifier (5') being connected to a splitter/combiner (6), said splitter/combiner (6) being linked via an output connector (3) to the unbalanced line.

2. Balun according to Claim 1, **characterised in that** the balanced line is a twisted-pair data line and the input connector (2) is a 4-pins/2-pairs Ethernet connector such as a RJ45 connector.

3. Balun according to Claim 2, **characterised in that** the twisted-pair data line is a 100 Ω nominal line suitable for use according to the Ethernet protocol with a base band signal rate of 10 Mb/s or 100 Mb/s.

4. Balun according to Claim 2 or 3, **characterised in that** the Transmit Data pins (TX+, TX-) are connected to the first line and the Receive Data pins (R+,R-) are connected to the second line.

5. Balun according to anyone of the preceding Claims, **characterised in that** the unbalanced line is a 75 Ω coaxial line and the output connector (3) is a RF connector.

6. Balun according to anyone of the preceding Claims, **characterised in that** the impedance adapters (4,4') are transformers having the same turn ratio equal to Nbal:Nunbal.

7. Balun according to Claim 6, **characterised in that** Nbal:Nunbal equals to 2/sqrt(3).

8. Balun according to Claim 5, **characterised in that** it is configured for connecting remote power over the coaxial line.

9. Balun according to Claim 5 in that it is configured to provide current limitation.

10. Balun according to Claim 3, **characterised in that** it is adapted for Ethernet Auto-Negotiation and 10 Base-T/100 Base-T half and full duplex mode.

11. Balun according to anyone of the preceding Claims, **characterised in that** it is configured to compensate for cable attenuation.

12. Balun according to anyone of the preceding Claims, **characterised in that** it is configured to simulate the desired cable characteristics.

13. Balun according to anyone of the preceding Claims, **characterised in that** it is configured to provide amplifier gains so that to tune overall loss.

14. Balun according to anyone of the preceding Claims, **characterised in that** said amplifiers (5,5') are active low-pass filters, i.e. operational amplifiers turned into low-pass filters.

15. Balun according to Claim 1, **characterised in that**, in each line, a group delay equalizer to compensate for the group delay of the low pass filter (8,8'), preferably up to 100 MHz, is inserted between each impedance adapter (4,4') and its corresponding amplifier (5,5').

16. Balun according to Claim 1, **characterised in that** the amplifiers (5,5') have dual supply, i.e. positive and negative voltage supply.

17. Balun according to Claim 1, **characterised in that** the splitter/combiner (6) is a high isolation splitter.

18. Network interface unit, preferably for 10/100 Base-T Ethernet and analogue TV applications, comprising at least one input, one output respectively, for an unbalanced analogue TV signal and one input, one output respectively, for a balanced data signal, at least one signal combiner, splitter respectively, for said unbalanced and said balanced signals and one output, one input respectively, for a combined unbalanced signal, **characterised in that** it further comprises an active balun according to anyone of the preceding claims, located between said balanced data signal input and an input of said combiner, between an output of said splitter and said balanced data signal output respectively.

19. Network interface unit according to Claim 18, **characterized in that** the input, output respectively, for unbalanced analogue TV signal and the output, input respectively, for said combined unbalanced signal are coax RF connectors while the input, output respectively, for balanced data signal is a twisted-pair, preferably RJ45, connector.

20. Network interface unit according to Claim 18 or 19, **characterized in that** it comprises a low-pass filter, preferably in the band 0-100 MHz, for filtering the data signal and a high-pass filter, preferably in the band 132-860 MHz, for filtering the analogue TV signal, before recombination, after splitting respectively, of the two signals.

21. Network interface unit, preferably for IP TV applications, comprising at least one input, one output respectively, for a balanced data signal and one output, one input respectively, for the corresponding unbalanced signal, **characterised in that** it further comprises an active balun according to anyone of Claims 1 to 17, located between said balanced data signal input, output respectively, and said unbalanced data signal output, input respectively.

22. Network interface unit according to anyone of Claims 18 to 21, **characterized in that** it further comprises a power inserter acting as a remote power supply (7) through the unbalanced line, preferably provided with a current limit element (10) configured so that to switch off the remote power supply (7) in case of short-circuit on the unbalanced line.
